Europäisches Patentamt

European Patent Office

Office européen des brevets

(19)

(11) **EP 1 422 722 A1**

(12) **EUROPEAN PATENT APPLICATION**
published in accordance with Art. 158(3) EPC

(43) Date of publication:
  **26.05.2004 Bulletin 2004/22**

(51) Int Cl.[7]: **G11C 16/06**

(21) Application number: **02746157.3**

(22) Date of filing: **01.08.2002**

(86) International application number:
  **PCT/JP2002/007880**

(87) International publication number:
  **WO 2003/015102 (20.02.2003 Gazette 2003/08)**

(84) Designated Contracting States:
  **AT BE BG CH CY CZ DE DK EE ES FI FR GB GR
  IE IT LI LU MC NL PT SE SK TR**

(30) Priority: **07.08.2001 JP 2001239377**

(71) Applicant: **Sharp Kabushiki Kaisha
  Osaka-shi, Osaka 545-8522 (JP)**

(72) Inventor: **OKUMURA, Hiroshi
  Joyo-shi, Kyoto 610-0121 (JP)**

(74) Representative: **Brown, Kenneth Richard et al
  R.G.C. Jenkins & Co.
  26 Caxton Street
  London SW1H 0RJ (GB)**

(54) **SYNCHRONOUS SEMICONDUCTOR STORAGE DEVICE MODULE AND ITS CONTROL METHOD, INFORMATION DEVICE**

(57)   A burst address arithmetic circuit **113** designates an access start address and a burst length based on an input address signal and a data signal, and calculates an access end address based on the access start address and the burst length. Based on an instruction from an internal control circuit **131A**, the burst address arithmetic circuit **113** sequentially updates addresses, counts the number of updates, and outputs each of the updated addresses to an address latch circuit **103**. When the updated address matches the address end address and also the number of time of update matches the burst length, the burst address arithmetic circuit **113** terminates its operation. When the updated address matches the last column address among column addresses corresponding to one row address, the burst address arithmetic circuit **113** changes the selection/non-selection state of the chip.

*FIG.1*

**Description**

**TECHNICAL FIELD**

The present invention relates to a synchronous-type semiconductor memory device module including a plurality of built-in synchronous-type semiconductor memory devices capable of performing burst output in synchronization with clock signals, a method for controlling the same, and an information device including the same.

**BACKGROUND ART**

Recent electronic devices mostly include built-in semiconductor memory devices (hereinafter, referred to as "memories"). The electronic devices perform various types of data processing based on data stored in the memories. Especially, central processing units (hereinafter, referred to as "CPUs") for executing the data processing have been significantly improved with respect to their processing speed. The processing capability of a CPU now exceeds 1 GHz in clock frequency. The data transfer speed between the memories and the CPU is critical to the processing capability of the entire system.

In order to cope with such a situation, high-speed accessing methods are used for accessing the memories under various special conditions in order that the accessing time is as close as possible to the processing speed of the CPU.

One such method is burst read from a synchronized flash memory used as a synchronous-type semiconductor memory device which operates in synchronization with a clock (hereinafter, referred to as "synchronous burst read"). According to synchronous burst read, only a first address for a series of data to be read is designated, and the subsequent addresses are processed in an incremental manner in the memory only by an externally input clock.

With such a method, the series of data to be read is restricted to be continuous from the first address, but there is an advantage that the read speed of the data stored at the subsequent addresses can be significantly higher than the read speed of the data stored at the first address.

This method is technologically suitable for high-speed operation, and is also suitable for collectively transferring a huge amount of data for applications of, for example, digital cameras and silicon audio which have been more and more widely used recently.

As well as the access speed to the memories, size reduction of electronic devices such as, for example, cellular phones, has been remarkably developed. For higher density planar mounting, a plurality of semiconductor chips are contained in one package. The external size of the package has also been reduced to be substantially equal to the chip size.

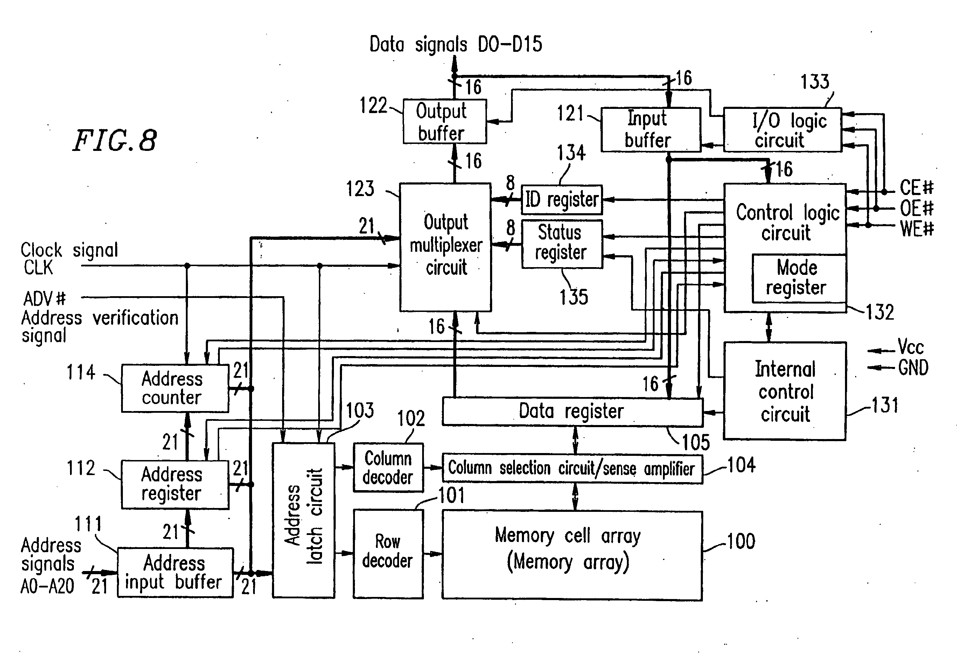

Figure 8 is a block diagram illustrating an internal structure of a conventional synchronous flash memory. The synchronous flash memory in this example is a 32 M bit memory including a structure of 2 M words $\times$ 16 bits.

First, external signals shown in Figure 8 and control modes will be described, and then the structure of each block of the memory will be described in detail.

Referring to Figure **8**, A0 through A20 each represent an address signal, and D0 through D15 each represent an input/output signal. A clock signal CLK is a master clock signal for the synchronous flash memory. In synchronization with the rise of the clock signal CLK, other external signals become valid. An address validation signal ADV# validates the address signals A0 through A20 when it is at a LOW level.

A chip enable signal CE#, when at a LOW level, indicates that the chip has been placed into an operational state. By the chip being placed into an operational state, the other external signals become valid. When the chip enable signal CE# is at a HIGH level, the other input signals are invalid. An output enable signal OE# and a write enable signal WE# are used for input/output control of data.

In this example, even when the chip enable signal CE# is changed from a LOW level to a HIGH level, the settings regarding the burst operation of the chip and so on are maintained. Even when the chip enable signal CE# is changed from a LOW level to a HIGH level, operations performed by internal algorithms such as, for example, an erase operation and a burst read operation, are continued until completed.

The synchronous flash memory can execute memory operations including data read, write, and erase, and various other setting operations by inputting commands using external signals. Each control command is defined by a combination of the address signals A0 through A20 and the data input/output signals D0 through D15. An input of a control command is taken in synchronization with the rise of a clock signal and decoded, and thus analyzed. An operation corresponding to the analysis result is executed.

The control commands are roughly classified into several types including read commands and write commands. Each type of command can further be classified. For example, the read commands can further be classified into, for example, read of an ID code, such as a manufacturer code or a device code, which is information for identifying the flash memory, read of a status register for storing setting states and execution results of various operations, and read of information stored in a memory array.

Setting commands can further be classified into, for example, setting of a burst length which represents an amount of data to be read at high speed continuously, setting of a latency which represents a time period (number of clocks) from issuance of a read command until output of data , setting of burst/page mode switching, and setting of a burst mode such as interleave or sequential. The terms "interleave" and "sequential" each refer to an address generation method in the flash memory. The burst length is usually set to, for example, "4", "8", "16" or "32".

The page mode is provided for high-speed read like the burst mode, but unlike the burst mode, does not require the data to be read to be continuous.

The burst mode is provided for obtaining a maximum possible high-speed accessing effect without relying on the architecture of the CPU externally used. The interleave mode is a system, used in the burst mode read, of outputting data in correspondence with internal addresses which are discontinuous in conformity with a certain rule. The sequential mode is a system, used in the burst mode read, of outputting data in correspondence with continuous internal addresses. Here, among the various types of burst mode, synchronous burst read in synchronization with a clock and the sequential burst mode will be mainly described.

Next, the structure of each block in Figure **8** will be described in detail.

Referring to Figure **8**, a semiconductor memory device **10** includes a memory cell array **100** (Memory Array), a row decoder **101** (Row Decoder), a column decoder **102** (Column Decoder), an address latch circuit **103** (Address Latch), a column selection circuit/sense amplifier **104** (Column Gating/Sensing) , a data register **105** (Data Register), an address input buffer **111** (Address Input Buffer) , an address register **112** (Address Register), an address counter **114** (Address Counter), an input buffer **121** (Input Buffer), an output buffer **122** (Output Buffer) , an output multiplexer circuit **123** (Output Multiplexer), an internal controlling circuit **131** (Controller), a control logic circuit **132** (Control Logic), an I/O logic circuit **133** (I/O Logic), an ID register **134** (ID Register), and a status register **135** (Status Register).

The memory cell array **100** includes a plurality of memory cells arranged in a matrix in a row direction and a column direction.

The row decoder **101** sequentially and selectively drives one of a plurality of word lines (not shown) in the memory array **100** in accordance with a decoding result of a row address signal.

The column decoder **102** outputs a decoding result of a column address signal to the column selection circuit/ sense amplifier **104.**

The address latch circuit **103** temporarily latches an input address signal taken from the address input buffer **111** described below, decodes the latched address signal in the row direction and the column direction, outputs an address in the row direction to the row decoder **101**, and outputs an address in the column direction to the column decoder **102**.

The column selection circuit/sense amplifier **104** includes a column selection circuit and a sense amplifier. The column selection circuit (switching circuit) is connected to a plurality of data lines (not shown) of the memory array **100,** and sequentially selects the data lines based on the decoding result from the column decoder **102** and controls the connection to the data register **105**. The column selection circuit also sequentially selects the data lines based on the decoding result from the column decoder **102** and controls the connection to the sense amplifier (amplification circuit). The sense amplifier (amplification circuit) performs sensing by amplifying a very fine potential difference, which is read from the memory cell via the selected data line, as information in the memory cell.

The data register **105** takes the data D0 through D15 from the input buffer **121** based on a control signal from the internal control circuit **131**, and outputs the data D0 through D15 to the column selection circuit/sense amplifier **104**. The data register **105** takes the data from the column selection circuit/sense amplifier **104**, and outputs the data to the output multiplexer circuit **123**.

The address input buffer **111** temporarily retains the address signals A0 through A20 supplied from an address input terminal.

The address register **112** takes the address signals A0 through A20 retained in the address input buffer **111.**

When the synchronous flash memory performs a synchronous burst read operation, the address counter **114** presets the output from the address register **112** as an initial value. The address counter **114** can output, to the address latch circuit **103**, values of address signals sequentially incremented from the preset data in accordance with the operation mode designated by the command, i.e., whether the read is a usual word-by-word read or a synchronous burst read.

The address counter **114** includes a comparator (not shown). The comparator compares each of the sequentially incremented addresses with the last address, and outputs each of the incremented address signals until the two addresses match each other. When the incremented address matches the last address, the comparator outputs the information representing the matching to the internal control circuit **131** via the control logic circuit **132**. In this case, the last address is obtained simply from a sum of the address retained in the address register **112** (first address for synchronous burst read) and the burst length.

The input buffer **121** temporarily retains the input data signals D0 through D15 which are input via a data input/output terminal.

The output buffer **122** temporarily retains output data signals D0 through D15 which are output via the output multiplexer circuit **123** described below.

The output multiplexer circuit **123** selects data of one of the ID register **134**, the status register **135** and the data register **105** , in accordance with the operation mode designated by the command, and outputs the data to the output buffer **122**. The ID register **134** and the status register **135** will be described below.

The internal control circuit **131** executes an internal algorithm required for the operation designated by the command, in accordance with the operation mode designated by the command.

The control logic circuit **132** distinguishes whether the data which is input via the input buffer **121** is a command or data. When a valid command is written, control information thereof is output to the internal control circuit **131**.

The control logic circuit **132** receives external control signals, such as the chip enable signal CE#, the output enable signal OE#, and the write enable signal WE#, command data supplied from the address register **112** (address section which forms commands), and command data which is input from the input buffer **121** (data section which forms commands). Based on the level change, the timing of these signals, or the like, an internal control signal for controlling the operation mode and the operations of the circuit blocks of the synchronous flash memory is generated. For this purpose, the control logic circuit **132** includes a control circuit and a mode register (Mode Register) therein.

The control logic circuit **132** outputs the device code to the ID register **134**, and outputs, to the status register **135**, the operational state of the internal control circuit **131** when the operation is terminated, the setting state of the current operation mode, and the like in accordance with the operation mode designated by the command. The control logic circuit **132** outputs, to the output multiplexer circuit **123,** a selection control signal for selecting the output data and a control signal for controlling whether the data is to be output to the output buffer **122**.

The input/output logic circuit **133** (I/O logic circuit) controls the input buffer **121** and the output buffer **122** based on the level change, timing, or the like of the external control signals, such as the chip enable signal CE#, the output enable signal OE#, the write enable signal WE# and the like. The input/output logic circuit **133** thus controls connection/disconnection between the internal data bus and the input/output data signals D0 through D15.

The ID register **134** stores the manufacturer code and the device code as information for identifying the flash memory.

The status register **135** stores the operation result, the operational state of the internal control circuit **131**, and various settings, such as write prohibition, which are obtained when the operation in accordance with the operation mode designated by the command is terminated.

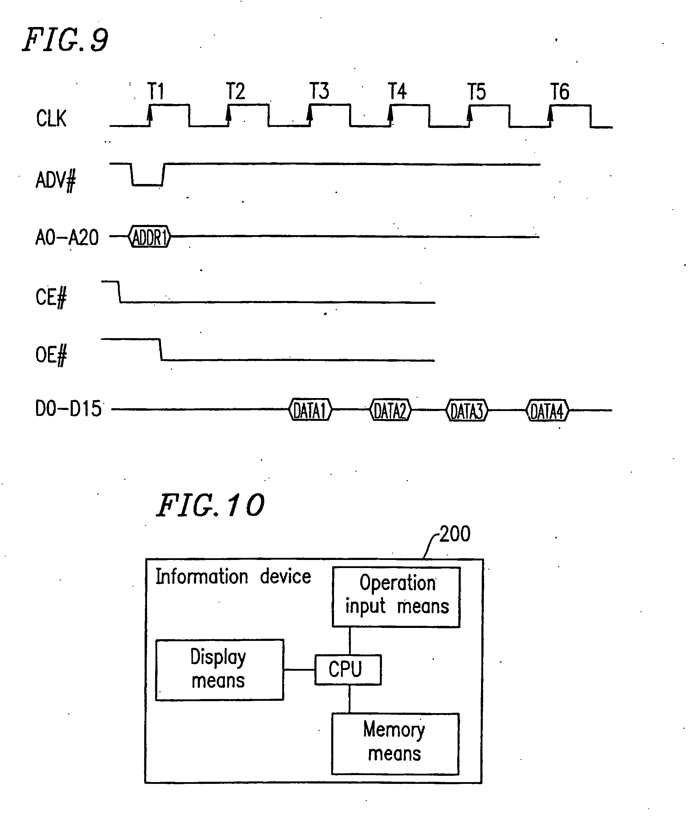

Figure 9 is a read timing diagram of a conventional synchronous flash memory in the case where the burst length = 4 and the latency = 2.

First, the chip enable signal CE# is changed to a LOW level. At the rise of a pulse time T1 of the clock CLK, the address validation signal ADV# is at a LOW level. A first address ADDR1 of the address signals A0 through A20 is input so as to change the output enable signal OE# to a LOW level, thereby starting burst read. After a two-clock setup period designated by the latency, at the rise of a pulse time T3 of the clock CLK, data DATA1 of the data signals D0 through D15 is output. After that, the data DATA2, DATA3, DATA4, ..., are sequentially and continuously output at high speed respectively in synchronization with pulse times T4, T5 and T6, ... of the clock CLK.

With the conventional synchronous memory, the number of columns included in one row of the memory array (the number of data lines in the memory array **100**) is the amount of data which can be sensed simultaneously by the column selection circuit/sense amplifier **104**. Since the data sensed simultaneously is output in a burst manner (continuously output) while being switched by the output multiplexer circuit **123**, a greater burst length cannot be set. Therefore, for performing burst read of the data having a burst length greater than the above-mentioned burst length, addresses need to be input again. While the addresses are input, the continuous data output is interrupted. For the same reason, data corresponding to different rows in the memory array cannot be continuously accessed since such accessing requires a sense operation.

As described above, it has become more and more common to enclose a plurality of semiconductor chips in one package. However, with the conventional flash memory, the advantage of such a manner of packaging is not considered. In more detail, in the case where a plurality of flash memories are enclosed in one package (hereinafter, a memory of such a packaged form will be referred to as a "nonvolatile semiconductor memory device module"), it would be convenient that the plurality of flash memories are usable in substantially the same manner as a single-body flash memory, irrespective of the inner structure of the package. A system for allowing a plurality of flash memories built in one package to be used in substantially the same manner as a single-body flash memory is required.

For example, Japanese Laid-Open Publication No. 3-260997 directed to "High-Speed Reading Method of ROM Data" discloses the following. When two or more memories are connected in parallel and chip enable signals CE# are provided independently, it is necessary to input addresses for the respective chips with shifted timings in order to read the data assigned to those different chips without interruption.

Conventionally, it is necessary to input an address a plurality of times in order to continuously read data assigned to a plurality of memory chips. A large amount of data cannot be read at high speed, using addresses which are input simultaneously.

**DISCLOSURE OF THE INVENTION**

The present invention, made in light of the above-described situation, has an objective of providing a synchronous-type semiconductor memory device module, in which even when a plurality of memory cells to be accessed without interruption are separately located in two memory chips, data can be read at high speed and with no interruption when access is changed from one chip to another, using the two memory chips substantially in the same manner as a single-body memory chip; a method for controlling the same; and an information device using the same.

According to the present invention, a synchronous-type semiconductor memory device module including a plurality of chips of synchronous-type semiconductor memory devices capable of performing continuous data read in synchronization with a clock is provided. Each of the plurality of synchronous-type semiconductor memory devices comprises information retaining means for retaining at least chip identification information, a chip selection state setting command, and an access start address; address arithmetic means for performing an arithmetic operation to obtain an access end address and performing an arithmetic operation to sequentially obtain updated addresses from the access start address to an access end address; and data continuous read control means for performing selection state/non-selection state switching of the plurality of synchronous-type semiconductor memory devices using the chip identification information and the chip selection state setting command, and for allowing data to be read from the synchronous-type semiconductor memory devices without interruption when one of the synchronous-type semiconductor memory devices is changed from the selection state to the non-selection state and another of the synchronous-type semiconductor memory devices is changed from the non-selection state to the selection state based on the updated addresses. Thus, the above-described objective are achieved.

Preferably, the address arithmetic means includes address initialization means for receiving, as inputs, an external control signal, an address signal and a data signal in synchronization with an external clock signal, and for setting an access start address and a burst length based on the input address signal and the input data signal and initializing a number of address updates; address update means for sequentially updating the address from the access start address and counting the number of address updates; and last address calculation means for calculating an access end address based on the burst length and the access start address.

Further preferably, the address arithmetic means includes first determination means for outputting a first determination signal to the data continuous read control means when the updated address matches a last column address among column addresses corresponding to one row address; and second determination means for outputting a second determination signal to the data continuous read control means when the updated address matches the access end address and also the number of address updates matches the burst length. The data continuous read control means includes chip selection state switching means for, based on the first determination signal, switching only a chip having the chip identification information which matches information designated by the chip selection setting command to a chip selection state; operation termination control means for performing operation termination processing based on the second determination signal; and data output control means for sequentially reading data corresponding to each of the updated addresses sequentially updated from the access start address from a chip in the selection state, without performing data read from a chip not in the selection state.

Further preferably, the data continuous read control means controls internal addresses such that: an address next to a last column address among column addresses corresponding to one row address of a memory cell array built in the first synchronous-type semiconductor memory device becomes a first column address of a row address, which corresponds to the one row address of the first synchronous-type semiconductor memory device, of a memory cell array built in the second synchronous-type semiconductor memory device, and an address next to a last column address among column addresses corresponding to one row address of the memory cell array built in the second synchronous-type semiconductor memory device becomes a first column address of a row address next to a row address, which corresponds to the one row address in the second synchronous-type semiconductor memory device, of the memory cell array built in the first synchronous-type semiconductor memory device.

Further preferably, N pieces of synchronous-type semiconductor memory devices (where N is a natural number) capable of performing a burst read operation in synchronization with a clock are included. The data continuous read control means controls internal addresses such that: an address next to a last column address of the row address of a memory cell array built in an arbitrary i'th synchronous-type semiconductor memory device, among a first through an (N-1)th synchronous-type semiconductor memory devices (where i is a natural number) becomes a first column address of a row address, corresponding to the one row address of the i'th synchronous-type semiconductor memory device, of a memory cell array built in the (i + 1)th synchronous-type semiconductor memory device, and an address next to a last column address among column addresses corresponding to one row address of the memory cell array built in an N'th synchronous-type semiconductor memory device becomes a first column address of a row address next to a row address, which corresponds to the one row address in the N'th synchronous-type semiconductor memory device, of the memory cell array built in the i'th synchronous-type semiconductor memory device.

Further preferably, the memory cells in the synchronous-type semiconductor memory devices are nonvolatile.

Further preferably, the memory cells in the synchronous-type semiconductor memory devices are flash memory cells.

Further preferably, associated external terminals of the plurality of synchronous-type semiconductor memory devices with respect to a given signal are all commonly connected.

Further preferably, the information retaining means has a word length for continuous read which is set therein.

A method for controlling a synchronous-type semiconductor memory device module according to the present invention includes a first step of inputting a burst length setting command, a chip selection setting command, a latency setting command for setting a latency from access start to data output, and an access start address; a second step of switching only a chip having chip identification information which matches information designated by the chip selection setting command to an active mode in which the chip can output data; a third step of setting the input access start address as an access start address and initializing a number of address updates; a fourth step of calculating an access end address based on the burst length and the access start address; a fifth step of outputting data corresponding to a current updated address in the active mode and not outputting data in a wait mode which is not the active mode; a sixth step of determining whether or not the current updated address matches the access end address and whether or not the number of address updates matches the burst length, and performing operation termination processing when both matches are confirmed; a seventh step of determining whether or not the current updated address matches the access end address and whether or not the number of address updates matches the burst length, when at least one of the matches is not confirmed, determining whether or not the current updated address is the last column address on one row address; an eighth step of, when the current updated address is not the last column address in the seventh step, incrementing the current column address and the number of address updates and returning the processing to the fifth step and the steps thereafter; a ninth step of, when the current updated address is the last column address in the seventh step, transferring the column address to the first address, incrementing the number of address updates, and determining a chip selection state; a tenth step of, when the chip is in the active mode in the ninth step, incrementing the row address, changing the chip into the wait mode, and returning the processing to the fifth step and the steps thereafter; and an eleventh step of, when the chip is in the wait mode in the ninth step, changing the chip into the active mode and returning the processing to the fifth step and the steps thereafter. Thus, the above-described objectives are achieved.

An information device according to the present invention uses any one of the above-described synchronous-type semiconductor memory device modules to perform a burst read operation. Thus, the above-described objectives are achieved.

The function of a synchronous-type semiconductor memory device module having the above-described structure will be described.

First of all, the present invention allows the selection/non-selection state of a plurality of synchronous-type semiconductor memory devices to be switched based on the updated address, and also allows data to be read from the plurality of synchronous-type semiconductor memory devices without interruption when one of the synchronous-type semiconductor memory devices is switched from the selection state to the non-selection state and another of the synchronous-type semiconductor memory devices is switched from the non-selection state to the selection state. A nonvolatile semiconductor memory device module having a longer burst length than that of a device having one memory chip is realized. For example, in the case where the nonvolatile semiconductor memory device module includes two memories having 32 M bit memories each having a 2 M words $\times$ 16 bit structure, the burst length of the module can be extended up to the total number of bits of the module, i.e., 32 M $\times$ 2 bits, at the maximum.

A nonvolatile semiconductor memory device module including a plurality of memory chips of any number of three or greater can have a still greater burst length by switching the memory chips to a selection state sequentially in a similar manner. This is especially effective for reading a huge amount of data for multi-media processing of image data and audio data, for booting a system program, or the like.

In the case where the order of the plurality of memory chips to be selected is preset or set by an external command input, the chips can be automatically switched to the chip selection state sequentially. Thus, the processing performed by the CPU to access the memories can be simplified and the load on the CPU can be alleviated.

As described above, according to the present invention, a module including a plurality of memory chips can be considered to be one memory device. By simply inputting an access start address and a burst length before the read, continuous high-speed data read can be performed. It is not necessary to control the plurality of memory chips separately.

In the case where the plurality of memory chips are mounted in one package in a stacked manner, the mounting area of the memory can be reduced and the production cost of the system can be reduced.

In addition, the module can comply with an increase in the memory capacity with the same number of pins and the same pin arrangement as those of one memory chip. This is highly advantageous to the user. Substantially the same effect can be provided in a nonvolatile semiconductor memory device module including chips mounted on a plurality of packages.

**BRIEF DESCRIPTION OF THE DRAWINGS**

Figure **1** is a block diagram illustrating a structure of a synchronous-type semiconductor memory device module including two synchronous flash memories according to an example of the present invention.

Figure **2** is a block diagram illustrating an internal structure of one of the synchronous flash memories shown in Figure **1**.

Figure **3** shows an exemplary memory map showing how addresses input to chip 1 and chip 2 are mapped in a row direction and a column direction, and the burst access order in such a case.

Figure **4** is a flowchart illustrating an exemplary control of the burst address arithmetic circuit and mode switching control during a synchronous burst read operation performed by an internal control circuit shown in Figure **2**.

Figure **5** is a timing diagram illustrating an operation (1) of the synchronous-type semiconductor memory device module shown in Figure **1**.

Figure **6** is a timing diagram illustrating an operation (2) of the synchronous-type semiconductor memory device module shown in Figure **1**.

Figure **7** is a block diagram illustrating a structure of a synchronous-type semiconductor memory device module including three synchronous flash memories according to another example of the present invention.

Figure **8** is a block diagram illustrating an internal structure of a conventional synchronous flash memory.

Figure **9** is a read timing diagram of a conventional synchronous flash memory when the burst length = 4 and the latency = 2.

Figure **10** is a block diagram illustrating a basic structure of an information device to which a synchronous-type semiconductor memory device module according to the present invention is applied.

**BEST MODE FOR CARRYING OUT THE INVENTION**

Hereinafter, a synchronous-type semiconductor memory device module and a method for controlling the same according to the present invention will be described by way of examples with reference to the drawings.

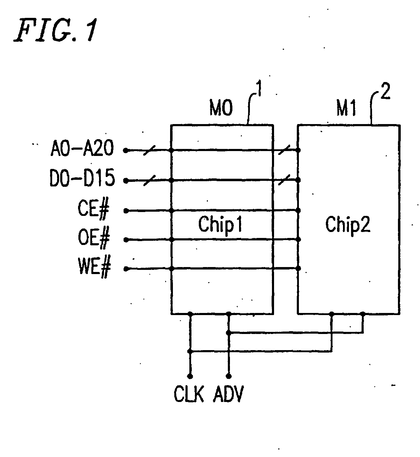

Figure **1** is a block diagram illustrating a synchronous-type semiconductor memory device module having two synchronous flash memories according to an example of the present invention.
In Figure **1,** the two synchronous flash memory chips each have a memory cell having a memory capacity of 32 Mbits, i.e., a 2 M words × 16 bit structure. Each type of signals, i.e., data input/output signals D0 through D15, address input signals A0 through A20, a chip enable signal CE#, an output enable signal OE#, a write enable signal WE#, a clock signal CLK, and an address validation signal ADV# are all commonly connected to the two synchronous flash memory chips.
The two synchronous flash memories each execute the algorithms for performing read operations in the memory independently, without mutually transferring control signals. The algorithms are performed in accordance with externally input commands including ID code read, status register read, and memory array read, and also commands for various settings including setting of the burst length, setting of the latency, burst/page switching setting, setting of the burst mode (i.e., interleave or sequential) . As such, the two synchronous flash memories built in the module are externally operated in the same manner as one synchronous flash memory.
Conventional chip operation modes include a wait state referred to as the "standby mode" and an operational state referred to as the "read mode" or the "write mode". In addition to these modes, the synchronous flash memory according to the present invention has a selection mode (Active Mode) and a non-selection mode (Wait Mode). The selection state is the state in which the chip outputs data, and the non-selection state is the state in which the chip does not output data. Hereinafter, the chip selection state will also be referred to as the selection mode, the selection state will also be referred to as the active mode, and the non-selection state will also be referred to as the wait mode.

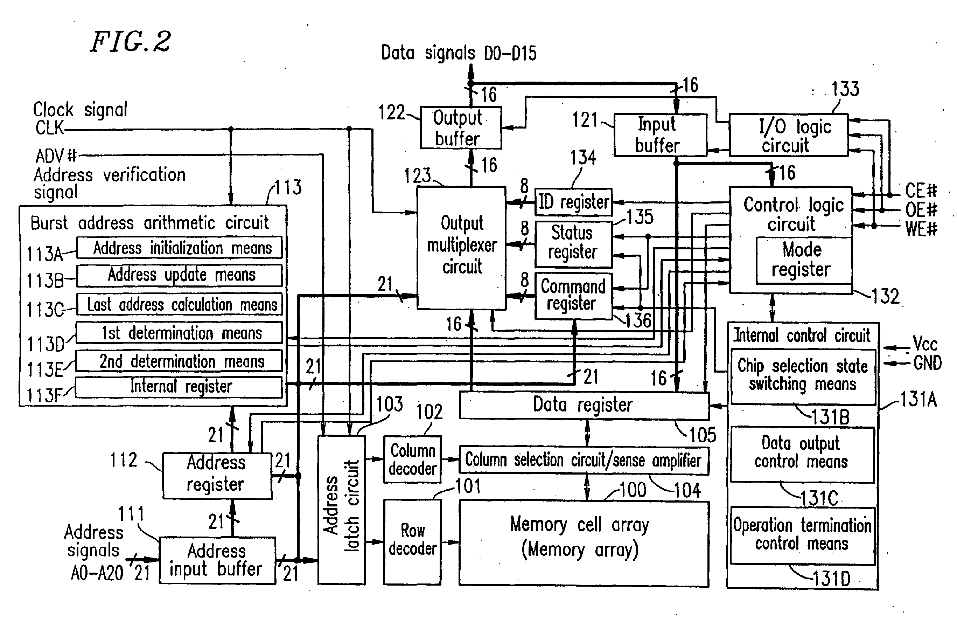

Figure **2** is a block diagram illustrating an internal structure of the synchronous flash memory shown in Figure **1**. Elements providing identical functions and effects as those in Figure **8** bear identical reference numerals, and descriptions thereof will be omitted.

The structure shown in Figure **2** is different from the structure shown in Figure **8** in that the address counter **114** in Figure **8** is replaced with a burst address arithmetic circuit **113** (Burst Address Arithmetic Circuit) as address arithmetic means, and that the command register **136** (Command Register) forming a part of the information retaining means is additionally provided. An internal control circuit **131A** acts as data continuous read control means, and controls the burst address arithmetic circuit **113** so as to execute synchronous burst read.

Hereinafter, the burst address arithmetic circuit **113** and the command register **136** will be described as features of the present invention. The control of the burst address arithmetic circuit **113** by the internal control circuit **131A** will also be described.

The burst address arithmetic circuit **113** includes: address initialization means **113A** for receiving an external control signal, an address signal, and a data signal in synchronization with an external clock signal, setting an access start address and a burst length based on the input address signal and the input data signal, and initializing a number of address updates; address update means **113B** for sequentially updating the address from the access start address and counting the number of address updates; last address calculation means **113C** for calculating an access end address based on the burst length and the access start address; first determination means **113D** for, when an updated address matches a last column address among column addresses corresponding to one row address, outputting a first determination signal representing the matches to the data continuous read control means; and second determination means **113E** for, when the updated address matches the access end address and the number of address updates also matches the burst length, outputting a second determination signal representing the matchings to the data continuous read control means.

For executing an operation mode designated by a command, for example, a synchronous burst read operation, the address initialization means **113A** and the address update means **113B** preset an address output from the address register **112** as initial data (access start address) in an internal register **113F** thereof (forming a part of the information retaining means) , and sequentially output each of values obtained by incrementing the address signal from the preset initial value to the address latch circuit **103** while counting the number of times that the value is output.

The last address calculation means **113C** has a calculation circuit (not shown) for calculating a last address by a method described below. In accordance with an algorithm for calculating the last address which is generated in the internal control circuit **131A**, a corresponding control signal is input from the control logic circuit **132** to the last address calculation means **113C**.

The second determination means **113E** has a comparator (not shown), and sequentially outputs each of address signals incremented until the address signal matches the last address calculated by the above-mentioned calculation circuit. When the output address matches the last address, the second determination means **113E** outputs information representing the matching (termination information) to the internal control circuit **131A** as a second determination signal via the control logic circuit **132**, in order to execute operation termination processing.

When the output address matches the last address on the selected word line (the last column address of one, same row address) also, the first determination means **113D** outputs information representing the matching (row address update and/or chip selection state update information) to the internal control circuit **131A** as a first determination signal via the control logic circuit **132**.

The command register **136** stores settings which are common with the conventional synchronous flash memory including setting of the burst length, setting of the latency, burst/page mode switching setting, and setting of the burst mode (i.e., interleave or sequential), and also the setting state of the chip selection designated by the commands added by the present invention, i.e. , the setting state of the selection mode. By this chip setting state, it can be distinguished whether or not the chip outputs data. The chip outputs data in the selection state and does not output data in the non-selection state. For example, whether the chip is chip 1 or chip 2 can be easily identified by presetting a unique number for each chip (chip identification information). The control operation by the internal control circuit **131A** according to the present invention based on this will be described in detail.

The internal control circuit **131A** includes: chip selection state switching means **131B** for switching, to the chip selection state, only the chip which has the chip identification information which matches the information designated by the chip selection setting command based on the first determination signal; operation termination control means **131C** for performing operation termination processing based on the second determination signal; and data output control means **131D** for controlling the chip in the chip selection state to sequentially read the data corresponding to each of the addresses sequentially updated from the access start address and controlling the chip not in the chip selection state (wait mode) not to read data.

An operation of continuously reading data corresponding to two synchronous flash memory chips (chip 1 and chip 2) without interruption will be described in further detail.

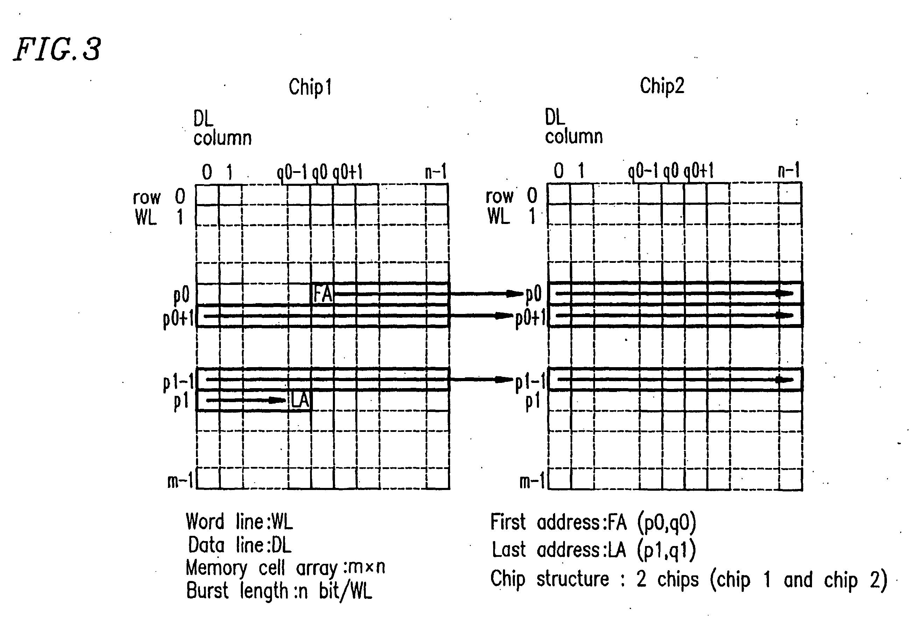

Figure 3 shows an exemplary memory map showing how the addresses input to chip 1 and chip 2 are mapped in the row direction and the column direction, and the burst access order in such a case. In Figure **3,** chip 1 and chip 2 each include a memory cell array including memory cells arranged in a matrix of m $\times$ n (m and n are each a natural number) in a row direction and a column direction. A maximum of n pieces of data can be read from one row address. In other words, n pieces of data are read in one sense operation, and therefore the maximum burst length per chip is n.

In Figure 3, the data is accessed at sequentially updated (for example, incremented) addresses from the access start address in chip 1 until the read of the last column data among column addresses corresponding to one row address is finished. At this point, the first determination means **113D** detects the last column address, and the chip selection state switching means **131B** switches the selection/non-selection state of the chips. Then, the processing advances to the first column data of the same row address of chip 2, which is placed into the selection state. When read of the last column data of that row address is finished, data is read from the first column data of the next row address of chip 1 by the function of the first determination means **113D** and the chip selection state switching means **131B**. The second determination means **113E** detects the last address, and the operation termination control means **131C** executes operation termination processing. In this manner, the memory cells are continuously accessed at high speed from the access start address in chip 1, then the addresses in chip 2, and the last address LA in chip 1, without interruption.

With reference to Figure **3**, an address arithmetic operation performed for reading pieces of data located separately in two synchronous flash memories without interruption will be described.

The read operation starts with an input coordinate (two-dimensional position of the memory cell) of a first address FA (p0, q0), which is the access start address. p0 is a row address and q0 is a column address. When the first address FA (p0, q0) is input, chip 1 in the selection state and chip 2 in the non-selection state select a corresponding word line p0. A last address is calculated based on the first address FA and the set burst length b.

Here, in order to simplify the calculation, the maximum burst length n is the same for chip 1 and chip 2, and the set burst length b is a value obtained by multiplying 2n by an integer. Where the first address is FA (p0, q0) and the set burst length is b, the last address LA (p1, q1) can be calculated as follows.

In the case of the sequential burst mode, the number of times that each chip selects the word line is b/2n when the column address of the first address FA (p0, q0) is q0 = 0, and b/2n + 1 when q0 $\neq$ 0.

Accordingly, the last address LA (p1, q1) can be calculated by following expression (1).

$$\text{When } q0 = 0,$$

$$(p1, q1) = [p0 + b/2n -1, n - 1]$$

$$\text{When } q0 \neq 0,$$

$$(p1, q1) = [p0 + b/2n, q0 - 1] \qquad\qquad \text{expression (1)}$$

The first address FA externally input is stored in the address register **112** forming a part of the information retaining means. The last address LA is calculated by the burst address arithmetic circuit **113** in accordance with expression (1) instructed by the internal control circuit **131A** via the control logic circuit **132**, and then is stored in a register in the burst address arithmetic circuit **113** forming a part of the information retaining means.

The currently updated address which is being accessed (hereinafter, referred to as the "current address") CA (p, q) is incremented in synchronization with the rise of the clock signal CLK from the first address FA as an initial value to the last address LA, and is output from the burst address arithmetic circuit **113** to the address latch circuit **103**. At this point, the current address CA (p, q) is latched by the register (not shown) built in the burst address arithmetic circuit **113** and is compared with the calculated last address LA.

Until the address CA (p, q) output from the burst address arithmetic circuit **113** reaches the last address LA, data on the word line sequentially selected in synchronization with the rise of the clock signal CLK is read from chip 1 in the selection state. Chip 2 in the non-selection state only counts the addresses at the rise of the clock signal CLK (corresponding to the counting operation of the burst length).

The burst address arithmetic circuit **113**, when detecting that the address CA (p, q) output from the burst address arithmetic circuit **113** matches the last address (p0, n-1) on the word line selected first before the address CA reaches the last address, outputs the information representing the matching as a first determination signal to the internal control circuit **131A** via the control logic circuit **132**. At this point, the chip selection state switching means **131B** of the internal control circuit **131A** of each of chip 1 and chip 2 switches the selection/non-selection state of the respective chip. As a result, chip 1 in the selection state is switched to the non-selection state, and chip 2 in the non-selection state is switched to the selection state. With no interruption, chip 2 in the selection state outputs data.

Although not shown, chip 1 which was the first to be in the selection state, when being switched from the selection state to the non-selection state, increments the row address so as to select and place the word line corresponding to the next address into the wait state and only counts the addresses at the rise of the clock signals CLK (corresponding to the counting operation of the burst length). This is performed such that data can be read without interruption at the next selection/non-selection switching.

Then, chip 2 in the selection state outputs data until the selection state reaches the last address (p0, n-1) on the selected word line is reached.

In this example, in order to simplify the calculation, the burst length n is the same for chip 1 and chip 2, and the set burst length b is a value obtained by multiplying 2n by an integer. Alternatively, it is possible to use two chips having arbitrarily different maximum burst lengths n and n' to arbitrarily set the set burst length b. Even when the set burst length b is smaller than the maximum burst lengths n and n' of the chips, the data can be read in the same manner as in the conventional device. By using the above-described method, data of the total number of bits of the nonvolatile semiconductor memory device module, at the maximum, can be continuously read without interruption, regardless of the maximum burst lengths of chips 1 and 2. Namely, in the case where there are two memories each having 32 M bits of a 2 M words × 16 bit structure, the data of 32 M × 2 bits can be continuously read without interruption.

Next, the control operation of the entire chip by the internal control circuit **131A** will be described in detail. In the internal control circuit **131A,** the address arithmetic operation and the mode switching operation, and control of the entirety of the chip are executed by a built-in program referred to as a "micro code".

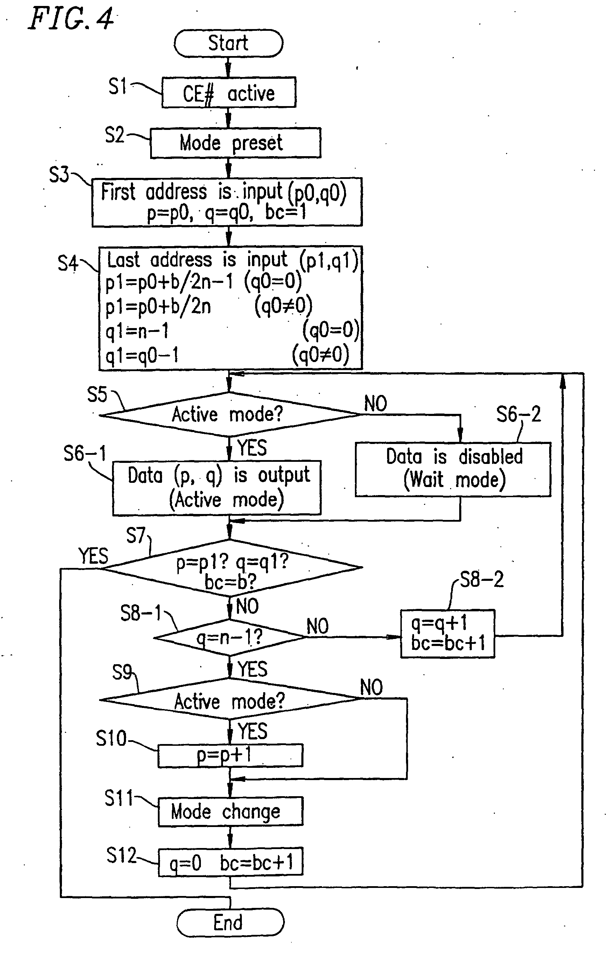

Figure **4** is a flowchart illustrating an exemplary control of the burst address arithmetic circuit and mode switching control during the synchronous burst read operation performed by the internal control circuit **131A** shown in Figure **2.** The processing operations are performed in synchronization with the rise of the clock signal CLK.

As shown in Figure **4**, in step S1, the chip enable signal CE# is changed to a LOW level, thereby starting a command input cycle.

Next, in step S2, setting commands including a burst length setting command, a chip selection setting command, a latency setting command, a burst/page switching setting command, a burst mode setting (interleave or sequential) command , or the like are written based on the address signal and data signal input (such settings will be referred to as the "mode preset").

The chip selection setting command is a command for setting each of the chips to the selection state (active mode) or the non-selection state (wait mode). A number is preset in each chip, such that only the chip having the preset number, which is designated by the input command, is switched to the selection (active) state. Thus, the modes and states are set as described above. In the case of a memory array read command, for example, the conventional flash memory operates based on a two cycle command system as follows. In the first cycle, FF (hexadecimal) instructing a read operation is input using the input/output data signals D0 through D7, among the input/output data signals D0 through D15. In the next cycle, the first address of the data to be read is input. The flash memory in this example operates based on a different two cycle command system as follows. In the first cycle, for example, EE (hexadecimal) is input as a chip selection setting command. In the next cycle, for example, a chip selection code is input such that when A0 (hexadecimal) is input, chip 1 is placed into the selection state, and when A1 (hexadecimal) is input, chip 2 is placed into the selection state. The command cycle of the external commands is defined by two cycles in this example, but the present invention is not limited to this. A larger number of commands can be set by increasing the number of command cycles.

Alternatively, the setting can be performed such that when F0 (hexadecimal), for example, is input in the first cycle, chip 1 is set to the chip selection state, and when FF (hexadecimal) is input in the first cycle, chip 2 is set to the chip selection state. In this case, the chip selection setting command and the memory array read command can be controlled in one cycle.

Here, each setting is retained until the synchronous flash memory is reset or turned off, although the present invention is not limited to this. Even during the synchronous flash memory is operating by a command input, the various setting commands can be input at any time, once an operation interruption command is input. The operation described so far is the initial setting. After this, a data read operation is performed based on an address input.

In step S3, the first address FA (p0, q0) is input, where the current address is CA (p, q) with p = p0 and q = q0 substituted therein. For the number of address increments bc, bc = 1 is the initial value. The number of address increments bc is the number of counted times that the burst address arithmetic circuit **113** increments the address in synchronization with the rise of the clock signal CLK. The number of address increments bc is latched in the register (not shown) built in the burst address arithmetic circuit **113**.

In step S4, the internal control circuit **131A** instructs the burst address arithmetic circuit **113** to calculate the last address LA (p1, q1). The calculation expression is different in accordance with the burst mode. In the case of the sequential burst mode of this example, the last address LA (p1, q1) is obtained by expression (1) with the above-mentioned conditions.

In step S5, the internal control circuit **131A** determines whether the chip is in the active mode or the wait mode.

When the chip is in the active mode, the data of the current address CA (p, q) is output in step S6-1. When the chip is in the wait mode, the processing advances to step S7 without any processing being performed in step S6-2.

Then, in step S7, it is determined whether or not the current address CA (p, q) matches the last address LA, and whether or not the number of address increments bc matches the set burst length b. When it is determined that the current address CA (p, q) in a selection state matches the last address LA and also the number of address increments bc matches the set burst length b, the operation is terminated. Otherwise, the processing advances to step S8-1.

In step S8-1, it is determined whether or not the current address CA (p, q) is the last address LA on the selected word line. When the current address CA (p, q) is not the last address LA on the selected word line, the column address and the number of address increments bc are incremented by the burst address arithmetic circuit **113** in step S8-2. When the current address CA (p, q) is the last address LA on the selected word line, the processing advances to steps S9 through S12 for operation mode switching.

In step S9, as in step S5, the state of the chip (whether the chip is in the active mode or wait mode) is determined. When the chip is in the active mode, the row address p latched in the burst address arithmetic circuit **113** is incremented in step S10 to (p + 1) so as to select the word line corresponding to the next address.

In step S11, the mode is changed to the wait mode for the preparation of the next selection mode switching.

When the chip is in the wait mode in step S9, the mode is changed to the active mode in step S11 for continuous data read.

In step S12, the column address q is reset, such that the first address becomes the column address of the current address CA (p, q). Then, the processing returns to step S5.

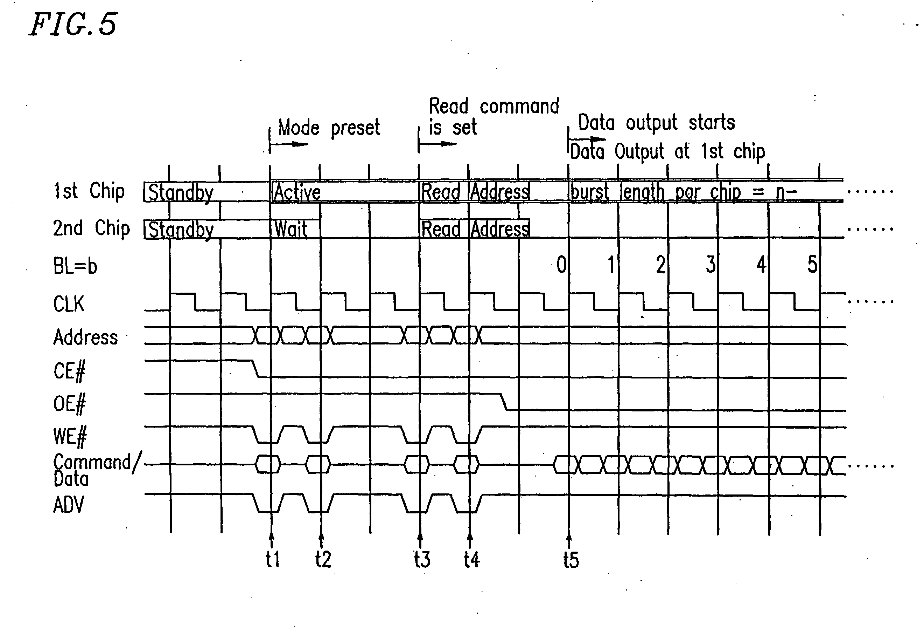

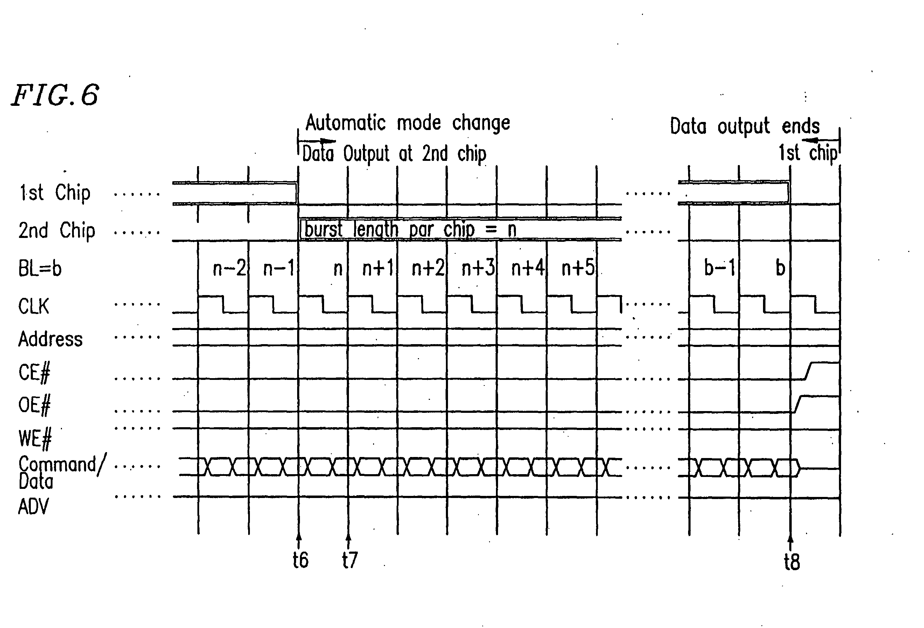

Figures **5** and **6** are timing diagrams illustrating operations of the synchronous-type semiconductor memory device module shown in Figure 1. Hereinafter, the timings of the operations will be described also with reference to the steps shown in the flowchart of Figure **4**. All the input signals are taken in the chip in synchronization with the rise of the clock signal CLK. The output signals become valid in synchronization with the rise of the clock signal CLK.

As shown in Figure **5**, before time t1, the chip enable signal CE# is at a HIGH level, and thus the nonvolatile semiconductor memory device module is in a wait state referred to as the "standby mode".

At time t1, the chip enable signal CE# which has been changed to a LOW level is input. As a result, the nonvolatile semiconductor memory device module is placed into the operational state; and commands, external signals and other inputs become valid. Times t1 and t2, for mode preset, correspond to step S1 (chip enable signal CE# being active) and step S2 (mode preset). The initial setting is input by the two-cycle command system of times t1 and t2. Although not shown, times t1 and t2 are repeated for performing the necessary types of settings. Namely, step S2 is repeated by the number of times corresponding to the number of commands for which the mode is preset. Thus, the necessary settings are performed. In the case of the two-cycle command system of times t1 and t2, for example, the type of the command is input at time t1 and a desired set value is input at time t2.

Times t3 and t4, for setting a read command, correspond to step S3. The read command and the first address are input by the two cycles of times t3 and t4, as in the case of times t1 and t2.

Time t5, for starting data output of chip 1, corresponds to steps S5 and S6. After this, the cycle of steps S5 through S8 is repeated for each clock until the data output is completed.

Then, as shown in Figure **6**, times t6 and t7, for automatic mode change (starting data output of chip 2), correspond to the cycle of steps S9 through S12.

The final time t8 is for terminating the data output. When the determination result in step S7 is "yes", the above-described series of processing is terminated.

As described above, in this example of the present invention, a nonvolatile semiconductor memory device module includes a plurality of synchronous flash memory chips having the same structure mounted on one package. All the associated external terminals of the synchronous flash memories are commonly connected. An external control signal, an address signal, and a data signal are input in synchronization with an external clock signal. Based on the input address signal and the input data signal, the address initialization means **113A** designates an access start address and a burst length, and also initializes the number of address updates. The last address calculation means **113C** calculates the access last address based on the access start address and the burst length. By an instruction from the data output control means **131D,** the address update means **113B** updates the address, counts the number of address updates, and outputs the updated address to the address latch circuit **103** so as to execute a burst read operation. The first determination means **113D** transfers the first determination signal, notifying that the updated address matches the last column address among column addresses corresponding to one row address, to the chip selection state switching means **131B**. Upon receiving the first determination signal, the chip selection state switching means **131B** switches only the chip which has chip identification information which matches the information designated by the chip selection setting command, to the chip selection state. The address update means **113B,** of the chip which is switched to the chip selection state, sequentially updates the address, counts the number of address updates, and outputs the updated address to the address latch circuit **103** so as to execute a burst read operation. Then, the second determination means **113E** transfers the second determination signal, notifying that the updated address matches the access last address and also the number of address updates matches the burst length, to the operation termination control means **131C**. Thus, the operation is terminated.

In the above-described manner, even when a plurality of memory cells to be accessed without interruption are separately located in two memory chips, the two memory chips having a large capacity in total can be used in substantially the same manner as a single-body memory chip with an address being input once. In addition, data can be read from one of the two memory chips and then from the other memory chip without interruption and at high speed.

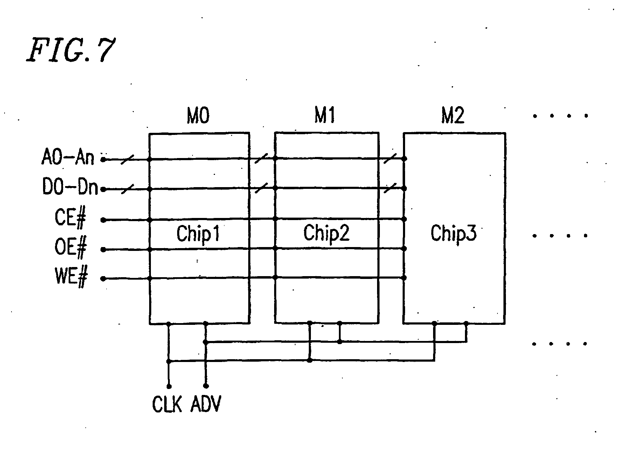

In Figure 1, two synchronous flash memory chips 1 and 2 are used. Alternatively, three synchronous flash memory chips 1 through 3 may be used as shown in Figure 7. In the case of Figure 7, the chips are sequentially placed into the selection state in the same manner as in the case of Figure 1. Thus, a nonvolatile semiconductor memory device module having a greater burst length can be realized. Similarly, a nonvolatile semiconductor memory device module including synchronous flash memories of any number of three or greater can be provided.

In this example, two chips, i.e., chip 1 or chip 2 can be selected by a command. In an alternative memory access method, for example, the memory device module is set, such that the first address is always of chip 1, and chip 2 is accessed without interruption when the set burst length b is longer than the maximum burst length n of chip 1. In the case where the first data to be read is in chip 2, the latency is increased but issuance and execution of the chip selection command for performing initial setting of the selection mode is not necessary. Either one of a shorter latency or non-necessity of issuance and execution of the chip selection command can be chosen in each individual case.

In this example, the sequential mode is used as the burst mode. The memory device module can be easily usable for the interleave mode. In this case, the internal control circuit **131A** changes the order of outputting data which is sensed by the column selection circuit/sense amplifier **104** and latched by the data register **105.**

Although not specified in this example, the above-described method is not limited to the case of two synchronous flash memories. Even when the memory device module includes synchronous flash memories of any number of three or greater, the chip in the selection state can be switched in the following manner. All the memory chips are provided with the priority order to be in the selection state, and the rise of the clock signal is counted. The chip in the selection state can be switched in accordance with the counted number. In this manner, a nonvolatile semiconductor memory device module having a greater burst length can be realized.

In this example, a module is formed using a nonvolatile semiconductor memory device, especially a synchronous flash memory. The present invention is not limited to this and is easily applicable to a module having a volatile memory cell array, for example, a dynamic RAM or a static RAM.

In this example, a synchronous-type semiconductor memory device module is described. The synchronous-type semiconductor memory device module according to the present invention may be incorporated into information devices such as cellular phone devices or computers, with the effect of the present invention being provided. For example, the synchronous-type semiconductor memory device module according to the present invention can easily be used for an information device **200** shown in Figure **10**. The information device **200** includes information storage means, such as a RAM and a ROM (synchronous-type semiconductor memory device module); control input means; display means, such as a liquid crystal display device for displaying an initial screen or an information processing result; and a CPU (central processing unit) for performing a burst read operation or the like from the information storage means, while processing various types of information upon receipt of a control instruction from the control input means based on a prescribed information processing program or data thereof. In the information device **200** having such a structure, the synchronous-type semiconductor memory device module according to the present invention can easily be used for the information storage means (RAM or ROM).

As described above, according to the present invention, the selection/non-selection state of a plurality of synchronous-type semiconductor memory devices is switched based on the updated address, and the data can be read at high speed from the plurality of synchronous-type semiconductor memory devices without interruption when one of the devices is switched from the selection state to the non-selection state and another device is switched from the non-selection state to the selection state. In addition, a nonvolatile semiconductor memory device module having a greater burst length than that of one memory chip can be realized. For example, in the case where the nonvolatile semiconductor memory device module includes two memories each having 32 M bits of a 2 M words $\times$ 16 bit structure, the burst length thereof can be extended, at the maximum, to the total number of bits of the module, i.e. , 32 M $\times$ 2 bits.

A nonvolatile semiconductor memory device module including a plurality of memory chips of any number of three or greater can have a still greater burst length by switching the memory chips to a selection state sequentially in a similar manner. This is especially effective for reading a huge amount of data for multi-media processing of image data and audio data, for booting a system program, or the like.

In the case where the order of the plurality of memory chips to be selected is preset or set by an external command input, the chips can be automatically switched to the chip selection state sequentially. Thus, the processing performed by the CPU to access the memories can be simplified and the load on the CPU can be alleviated.

As described above, according to the present invention, a module including a plurality of memory chips can be considered to be one memory device. By simply inputting an access start address and a burst length before the read, continuous high-speed data read can be performed. It is not necessary to control the plurality of memory chips separately.

In the case where the plurality of memory chips are mounted in one package in a stacked manner, the mounting area of the memory can be reduced and the production cost of the system can be reduced.

In addition, the module can comply with an increase in the memory capacity with the same number of pins and the same pin arrangement as those of one memory chip. This is highly advantageous to the user. Substantially the same effect can be provided in a nonvolatile semiconductor memory device module including chips mounted on a plurality of packages.

## INDUSTRIAL APPLICABILITY

In the technical field of a synchronous-type semiconductor memory device module including a plurality of chips of synchronous-type semiconductor memory devices capable of performing burst output in synchronization with a clock, even where a plurality of memory cells to be accessed without interruption are separately located in two memory chips, the two memory chips of a large capacity in total can be used in substantially the same manner as a single-body memory chip with an address being input once.

## Claims

1. A synchronous-type semiconductor memory device module including a plurality of chips of synchronous-type semiconductor memory devices capable of performing continuous data read in synchronization with a clock, wherein each of the plurality of synchronous-type semiconductor memory devices comprises:

    information retaining means for retaining at least chip identification information, a chip selection state setting command, and an access start address;
    address arithmetic means for performing an arithmetic operation to obtain an access end address and performing an arithmetic operation to sequentially obtain updated addresses from the access start address to an access end address; and
    data continuous read control means for performing selection state/non-selection state switching of the plurality of synchronous-type semiconductor memory devices using the chip identification information and the chip selection state setting command, and for allowing data to be read from the synchronous-type semiconductor memory devices without interruption when one of the synchronous-type semiconductor memory devices is changed from the selection state to the non-selection state and another of the synchronous-type semiconductor memory devices is changed from the non-selection state to the selection state based on the updated addresses.

2. A synchronous-type semiconductor memory device module according to claim 1, wherein the address arithmetic means includes:

    address initialization means for receiving, as inputs, an external control signal, an address signal and a data signal in synchronization with an external clock signal, and for setting an access start address and a burst length based on the input address signal and the input data signal and initializing a number of address updates;
    address update means for sequentially updating the address from the access start address and counting the number of address updates; and
    last address calculation means for calculating an access end address based on the burst length and the access start address.

3. A synchronous-type semiconductor memory device module according to claim 1 or 2, wherein:

    the address arithmetic means includes first determination means for outputting a first determination signal to the data continuous read control means when the updated address matches a last column address among column addresses corresponding to one row address; and second determination means for outputting a second determination signal to the data continuous read control means when the updated address matches the access end address and also the number of address updates matches the burst length; and
    the data continuous read control means includes chip selection state switching means for, based on the first determination signal, switching only a chip having the chip identification information which matches information designated by the chip selection setting command to a chip selection state; operation termination control means for performing operation termination processing based on the second determination signal; and data output control means for sequentially reading data corresponding to each of the updated addresses sequentially updated from the access start address from a chip in the selection state, without performing data read from a chip not in the selection state.

4. A synchronous-type semiconductor memory device module according to claim 1, wherein the data continuous read control means controls internal addresses such that:

an address next to a last column address among column addresses corresponding to one row address of a memory cell array built in the first synchronous-type semiconductor memory device becomes a first column address of a row address, which corresponds to the one row address of the first synchronous-type semiconductor memory device, of a memory cell array built in the second synchronous-type semiconductor memory device, and

an address next to a last column address among column addresses corresponding to one row address of the memory cell array built in the second synchronous-type semiconductor memory device becomes a first column address of a row address next to a row address, which corresponds to the one row address in the second synchronous-type semiconductor memory device, of the memory cell array built in the first synchronous-type semiconductor memory device.

5. A synchronous-type semiconductor memory device module according to claim 1, wherein:

N pieces of synchronous-type semiconductor memory devices (where N is a natural number) capable of performing a burst read operation in synchronization with a clock are included, and

the data continuous read control means controls internal addresses such that:

an address next to a last column address among the row address of a memory cell array built in an arbitrary i'th synchronous-type semiconductor memory device, among a first through an (N-1)th synchronous-type semiconductor memory devices (where i is a natural number) becomes a first column address of a row address, corresponding to the one row address of the i'th synchronous-type semiconductor memory device, of a memory cell array built in the (i + 1)th synchronous-type semiconductor memory device, and

an address next to a last column address among column addresses corresponding to one row address of the memory cell array built in an N'th synchronous-type semiconductor memory device becomes a first column address of a row address next to a row address, which corresponds to the one row address in the N'th synchronous-type semiconductor memory device, of the memory cell array built in the i'th synchronous-type semiconductor memory device.

6. A synchronous-type semiconductor memory device module according to claim 1, wherein the memory cells in the synchronous-type semiconductor memory devices are nonvolatile.

7. A synchronous-type semiconductor memory device module according to claim 1, wherein the memory cells in the synchronous-type semiconductor memory devices are flash memory cells.

8. A synchronous-type semiconductor memory device module according to claim 1, wherein associated external terminals of the plurality of synchronous-type semiconductor memory devices with respect to a given signal are all commonly connected.

9. A synchronous-type semiconductor memory device module according to claim 1, wherein the information retaining means has a word length for continuous read which is set therein.

10. A method for controlling a synchronous-type semiconductor memory device module, comprising:

a first step of inputting a burst length setting command, a chip selection setting command, a latency setting command for setting a latency from access start to data output, and an access start address;

a second step of switching only a chip having chip identification information which matches information designated by the chip selection setting command to an active mode in which the chip can output data;

a third step of setting the input access start address as an access start address and initializing a number of address updates;

a fourth step of calculating an access end address based on the burst length and the access start address;

a fifth step of outputting data corresponding to a current updated address in the active mode and not outputting data in a wait mode which is not the active mode;

a sixth step of determining whether or not the current updated address matches the access end address and whether or not the number of address updates matches the burst length, and performing operation termination processing when both matches are confirmed;

a seventh step of determining whether or not the current updated address matches the access end address and whether or not the number of address updates matches the burst length, when at least one of the matches is not confirmed, determining whether or not the current updated address is the last column address on one row address;

an eighth step of, when the current updated address is not the last column address in the seventh step, incrementing the current column address and the number of address updates and returning the processing to the fifth step and the steps thereafter;

a ninth step of, when the current updated address is the last column address in the seventh step, transferring the column address to the first address, incrementing the number of address updates, and determining a chip selection state;

a tenth step of, when the chip is in the active mode in the ninth step, incrementing the row address, changing the chip into the wait mode, and returning the processing to the fifth step and the steps thereafter; and

an eleventh step of, when the chip is in the wait mode in the ninth step, changing the chip into the active mode and returning the processing to the fifth step and the steps thereafter.

11. An information device for using a synchronous-type semiconductor memory device module according to claim 1 to perform a burst read operation.

FIG. 1

*FIG.2*

Data signals D0–D15

Clock signal CLK

ADV# Address verification signal

Burst address arithmetic circuit — 113
- 113A — Address initialization means
- 113B — Address update means
- 113C — Last address calculation means
- 113D — 1st determination means
- 113E — 2nd determination means
- 113F — Internal register

122 — Output buffer — 16

123 — Output multiplexer circuit — 16

121 — Input buffer — 16

133 — I/O logic circuit

134 — ID register — 8
135 — Status register — 8
136 — Command register — 8

Control logic circuit
Mode register — 132

CE#
OE#
WE#

Internal control circuit — Vcc, GND
Chip selection state switching means — 131A — 131B

Data output control means — 131C

Operation termination control means — 131D

112 — Address register — 21
111 — Address input buffer — 21

Address signals A0–A20 — 21

103 — Address latch circuit
102 — Column decoder
101 — Row decoder

Column selection circuit/sense amplifier — 104
Data register — 105

Memory cell array (Memory array) — 100

EP 1 422 722 A1

FIG.3

## FIG.4

Start

S1 — CE# active

S2 — Mode preset

S3 — First address is input (p0,q0)
p=p0, q=q0, bc=1

S4 — Last address is input (p1,q1)
$p1=p0+b/2n-1$ $(q0=0)$
$p1=p0+b/2n$ $(q0\neq0)$
$q1=n-1$ $(q0=0)$
$q1=q0-1$ $(q0\neq0)$

S5 — Active mode? — NO → S6-2 Data is disabled (Wait mode)

YES

S6-1 — Data (p, q) is output (Active mode)

S7 — p=p1? q=q1? bc=b? — YES

NO

S8-1 — q=n-1? — NO → S8-2 q=q+1 bc=bc+1

YES

S9 — Active mode? — NO

YES

S10 — p=p+1

S11 — Mode change

S12 — q=0  bc=bc+1

End

# FIG.5

EP 1 422 722 A1

## FIG. 6

Automatic mode change
Data Output at 2nd chip

Data output ends
1st chip

| | | n-2 | n-1 | n | n+1 | n+2 | n+3 | n+4 | n+5 | | b-1 | b |

1st Chip

2nd Chip · · · · · · burst length par chip = n

BL=b

CLK

Address

CE#

OE#

WE#

Command/
Data

ADV

t6    t7                                    t8

EP 1 422 722 A1

FIG.7

# FIG.8

Data signals D0–D15

Output buffer — 122

16

Input buffer — 121

16

I/O logic circuit — 133

16

CE#
OE#
WE#

ID register — 134

Status register — 135

8

8

Control logic circuit

Mode register — 132

Output multiplexer circuit — 123

21

16

16

Clock signal CLK

ADV#
Address verification signal

Internal control circuit — 131

Vcc
GND

Address counter — 114

21

Data register — 105

16

Address register — 112

21

21

Column decoder — 102

Column selection circuit/sense amplifier — 104

Address signals A0–A20

Address input buffer — 111

21

21

21

21

Address latch circuit — 103

Row decoder — 101

Memory cell array (Memory array) — 100

EP 1 422 722 A1

# FIG.9

# FIG.10

## INTERNATIONAL SEARCH REPORT

International application No.

PCT/JP02/07880

| A. CLASSIFICATION OF SUBJECT MATTER |
|---|
| Int.Cl⁷ G11C16/06 |

According to International Patent Classification (IPC) or to both national classification and IPC

| B. FIELDS SEARCHED |
|---|
| Minimum documentation searched (classification system followed by classification symbols)<br>Int.Cl⁷ G11C16/06, G11C11/4063, G11C11/413 |

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2002 |
| Kokai Jitsuyo Shinan Koho | 1971-2002 | Toroku Jitsuyo Shinan Koho | 1994-2002 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| A | JP 5-282882 A (Toshiba Corp.),<br>29 October, 1993 (29.10.93),<br>Full text; all drawings<br>& US 5297029 A    & KR 9612359 B | 1-11 |
| A | JP 6-149662 A (Toshiba Corp.),<br>31 May, 1994 (31.05.94),<br>Full text; all drawings<br>& US 5550996 A    & GB 2272088 A<br>& KR 9606496 B | 1-11 |
| A | JP 11-203860 A (NEC Corp.),<br>30 July, 1999 (30.07.99),<br>Full text; all drawings<br>& US 6345334 B    & DE 19900365 A<br>& CN 1225492 A | 1-11 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>05 November, 2002 (05.11.02) | Date of mailing of the international search report<br>03 December, 2002 (03.12.02) |
|---|---|
| Name and mailing address of the ISA/<br>Japanese Patent Office | Authorized officer |
| Facsimile No. | Telephone No. |

Form PCT/ISA/210 (second sheet) (July 1998)

**EP 1 422 722 A1**

## INTERNATIONAL SEARCH REPORT

International application No.

PCT/JP02/07880

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2001-184874 A  (Sony Corp.),<br>06 July, 2001 (06.07.01),<br>Full text; all drawings<br>(Family: none) | 1-11 |

Form PCT/ISA/210 (continuation of second sheet) (July 1998)